# NEUE EUROPÄISCHE PATENTSCHRIFT

(11) **EP 1 262 021 B2**
(45) Veröffentlichungstag und Bekanntmachung des Hinweises auf die Entscheidung über den Einspruch: **05.09.2012**
(45) Hinweis auf die Patenterteilung: 02.01.2004
(21) Anmeldenummer: 01915318.8
(22) Anmeldetag: 06.03.2001
(51) Int. Cl.: H03K 19/007, F16P 3/00

(54) **SICHERHEITSSCHALTGERÄT UND SICHERHEITSSCHALTGERÄTE-SYSTEM**
SECURITY SWITCHING DEVICE AND A SYSTEM OF SECURITY SWITCHING DEVICES
APPAREIL DE COMMUTATION DE SECURITE ET SYSTEME D'APPAREILS DE COMMUTATION DE SECURITE

(30) Priorität: 08.03.2000 DE 10011211
(43) Veröffentlichungstag der Anmeldung: 04.12.2002
(73) Patentinhaber: Pilz GmbH & Co.., 73760 Ostfildern (DE)
(72) Erfinder: PULLMANN, Jürgen, 73061 Ebersbach (DE); VEIL, Richard, 70597 Stuttgart (DE)
(74) Vertreter: Duhme, Torsten
(86) Internationale Anmeldenummer: PCT/EP2001/002561
(87) Internationale Veröffentlichungsnummer: WO 2001/067610

(56) Entgegenhaltungen:
- WO-A1-97/37168
- DE-A- 2 109 202
- DE-A- 19 626 129
- DE-A1- 3 135 888
- DE-A1- 3 513 357
- DE-A1- 4 217 694
- DE-A1- 19 508 841
- DE-A1- 19 534 715
- DE-A1- 19 707 241
- DE-A1- 19 805 722
- DE-C- 19 736 183
- DE-C2- 4 242 792
- DE-C2- 4 441 070
- US-A- 5 999 395
- K.MEYER: "sicherheitssysteme für elektronisch gesteuerte Anlagen" ELEKTRONIK, Bd. 26, Nr. 11, November 1977 (1977-11), Seiten 59-64, XP002169902 münchen,DE
- E.STRANG: "überwachungsbausteine für fehlersichere Signalverarbeitung" TECHNISCHE MITTEILUNGEN AEG-TELEFUNKEN, Bd. 58, 1968, Seiten 179-181, XP002169903 frankfurt
- "digithom II- relayage statique de sécurité" ELECTRONIQUE INDUSTRIELLE, Februar 1967 (1967-02), Seiten 131-133, XP002169904 paris,fr
- SICK AG: 'Operating instructions "LCU-P Programmable Safety Interface"' Bd. 8008364.0999, Seiten 1 - 35
- LEUZE LUMIFLEX: 'Anschluss- u. Betriebsanleitung "Modulares Sicherheits-Interface MSI-mx/Rx MSI-mx/Tx"' Bd. 603600-07/99, Juli 1999 - Juli 1999, Seiten 1 - 48
- BÖGE, A.: 'Das Techniker Handbuch, 10. Auflage', 1987, FRIEDR. VIEWEG & SOHN VERLAGSGESELLSCHAFT MBH, BRAUNSCHWEIG, ISBN 3528840536 Seiten 1460 - 1461
- 'BIA-Handbuch "Sicherheit und Gesundheitsschutz am Arbeitsplatz", 10. Lfg. X/88', Bd. 2, 1985, ERICH SCHMIDT VERLAG, BIELEFELD, ISBN 3503020306, ISSN 09334629 Seiten 1 - 7
- TIETZE, U., SCHENK, CH.: 'Halbleiter-Schaltungstechnik, 2. Auflage', 1971, SPRINGER-VERLAG Seite 102, 423
- REISS, K.: 'Integrierte Digitalbausteine, Kleines Praktikum, Seiten 26, 40, 41, 62, 68' 1970 - 1970, SIEMENS AKTIENGESELLSCHAFT,
- KORTHALS ALTES: 'Philips Taschenbücher "Logische Schaltungen mit Transistoren", 2. Aufl., Seiten 46-49, 56,57', 1966
- SIEMENS AG: 'Applikationshandbuch "Safety Integrated: Das Sicherheitsprogramm für die Industrien der Welt", Seiten 4/14, 4/16, 4/17', 1999, BERLIN UND MÜNCHEN
- HÖLSCHER, H., RADER, J.: 'Mikrocomputer in der Sicherheitstechnik, Eine Orientierungshilfe für Entwickler und Hersteller, Seiten 7-9, 7-11, 7-13, 7-15, 7-64, 7-65, 7-66, 7-67, 7-69, 7-70', 1984, VERLAG TÜV RHEINLAND, KÖLN, ISBN 3885851806

## Beschreibung

Die vorliegende Erfindung betrifft ein Sicherheitsschaltgerät zum Ein- und sicheren Ausschalten eines elektrischen Verbrauchers, insbesondere einer elektrisch angetriebenen Maschine, nach dem Oberbegriff von Anspruch 1.

Die Erfindung betrifft ferner ein Sicherheitsschaltgeräte-System mit zumindest zwei zuvor genannten Sicherheitsschaltgeräten.

Gattungsgemäße Sicherheitsschaltgeräte werden vor allem im industriellen Bereich verwendet, um elektrisch angetriebene Maschinen, wie beispielsweise eine Presse oder ein Fräswerkzeug, ein- und vor allem sicher auszuschalten. Sie dienen insbesondere in Verbindung mit einem mechanisch betätigbaren Not-Aus-Taster dazu, die Maschine in einer Notfallsituation schnell und zuverlässig abzuschalten. Hierzu wird in der Regel die Stromversorgung der abzuschaltenden Maschine über die Arbeitskontakte von zwei Schaltelementen geführt. Die Schaltelemente werden von dem Sicherheitsschaltgerät in einer fehlersicheren Art und Weise angesteuert. Sobald auch nur eines der beiden Schaltelemente seine Arbeitskontakte öffnet, wird die Stromzuführung der Maschine unterbrochen.

Sicherheitsschaltgeräte der vorliegenden Art benötigen aufgrund ihrer Verwendung in sicherheitskritischen Bereichen in vielen Ländern eine gesonderte Zulassung. Dabei wird die Eigenfehlersicherheit der Geräte überprüft. Sicherheitsschaltgeräte im Sinne der vorliegenden Erfindung sind daher nur solche, die aufgrund einer entsprechenden Zulassung für eine sicherheitskritische Verwendung geeignet sind, insbesondere solche, die die Sicherheitskategorie 3 oder höher der europäischen Norm EN 954-1 erfüllen. Des weiteren fallen unter den Begriff Sicherheitsschaltgeräte hier nur Geräte mit einer vom Hersteller im wesentlichen fest implemetierten Funktionalität, bspw. als Schutztürüberwachungsgerät oder als zweikanaliges Not-Aus-Schaltgerät. Solche Geräte können zwar teilweise in vorgegebenen Grenzen parametriert werden, sie sind jedoch in ihrer Grundfunktion festgelegt und daher im Gegensatz zu einer Sicherheitssteuerung vom Anwender nicht frei programmierbar.

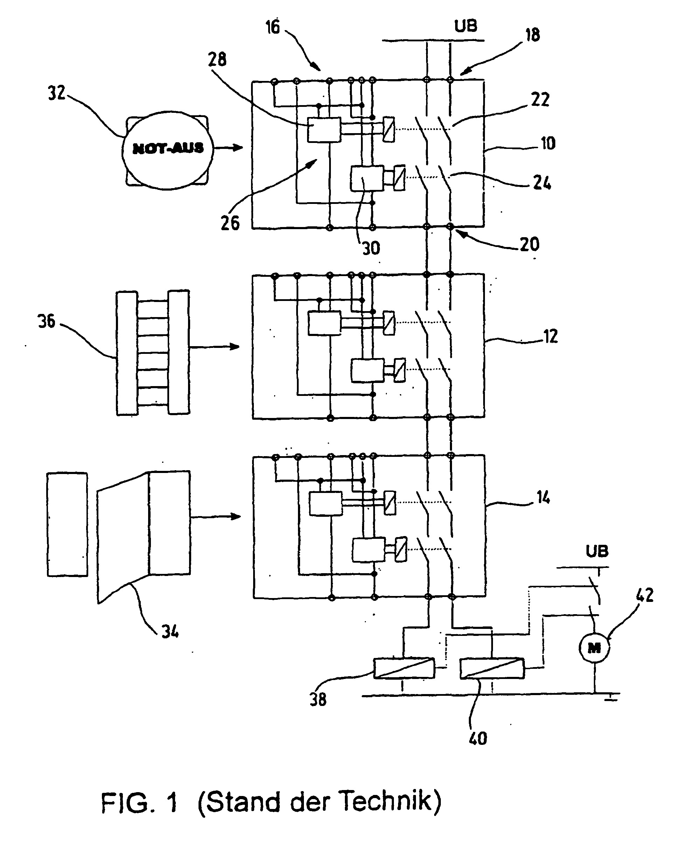

In der Praxis bewährte Sicherheitsschaltgeräte sind bis heute weitgehend elektromechanisch aufgebaut, d.h. die genannten Schaltelemente sind Relais oder Schütze. Ein Beispiel für ein solches Sicherheitsschaltgerät ist aus DE 197 36 183 C1 bekannt. Zur Veranschaulichung einer üblichen Anwendung dieser herkömmlichen Sicherheitsschaltgeräte sind in Fig. 1 drei bekannte Sicherheitsschaltgeräte dargestellt und mit den Bezugszeichen 10, 12, 14 gekennzeichnet.

Jedes Sicherheitsschaltgerät 10, 12, 14 ist ein kompaktes, eigenständiges Gerät mit einer vorgegebenen Funktionalität. Es ist jeweils in einem hier nicht explizit dargestellten Gehäuse untergebracht, das die elektrischen und elektromechanischen Bauelemente aufnimmt. Die Einspeisung von eingangsseitigen Schaltsignalen und die Ausgabe von Ausgangssignalen erfolgt über Eingangsklemmen 16 sowie Ausgangsklemmen 18, 20, die an der Außenseite des Gehäuses zugänglich angeordnet sind. Charakteristisch bei diesen herkömmlichen Sicherheitsschaltgeräten ist, daß sie jeweils zumindest zwei Ausgangsklemmen 18, 20 aufweisen, die jeweils ein Ausgangsklemmenpaar bilden und zwischen denen die Arbeitskontakte 22, 24 der elektromechanischen Schaltelemente angeordnet sind.

Jedes Sicherheitsschaltgerät 10, 12, 14 besitzt im Inneren des Gehäuses ferner eine fehlersichere Auswerte- und Steuereinheit 26, die ein eingangsseitges Schaltsignal fehlersicher auswertet und in Abhängigkeit davon die Arbeitskontakte 22, 24 ansteuert. Je nach Ausführungsvariante und geforderter Sicherheitskategorie ist die Auswerteeinheit 26 einkanalig oder mehrkanalig ausgebildet. In Fig. 1 besitzt jede Auswerteeinheit 26 jeweils zwei Auswertekanäle 28, 30. Im Normalbetrieb sind die Arbeitskontakte 22, 24 der Sicherheitsschaltgeräte geschlossen, so daß eine durchgehende Verbindung zwischen den Ausgangsklemmen 18 und 20 hergestellt wird. Wenn die beiden Auswertekanäle 28, 30 ein eingangsseitiges Schaltsignal erkennen, werden die Arbeitskontakte 22, 24 geöffnet, so daß die Verbindung zwischen den Ausgangsklemmen 18 und 20 unterbrochen wird. Diese Unterbrechung hat dann zur Folge, daß eine entsprechende Maschine angehalten wird.

In der Praxis kommt es sehr häufig vor, daß mehrere Schaltereignisse, beispielsweise das Betätigen eines Not-Aus-Schalters 32, das Öffnen einer Schutztür 34 oder das Durchgreifen eines Lichtvorhangs 36 UND-verknüpft werden müssen. Hierzu werden, wie in Fig. 1 dargestellt, die Arbeitskontakte 22, 24 mehrerer Sicherheitsschaltgeräte 10, 12, 14 in Reihe geschaltet. Das letzte Sicherheitsschaltgerät 14 dieser Reihe ist dabei häufig mit externen Schützen 38, 40 verbunden, die die Energieversorgung der Maschine 42 ein- oder ausschalten. Im Normalbetrieb sind alle Arbeitskontakte 22, 24 geschlossen. Damit sind die Schütze 38, 40 bestromt und die Energieversorgung ist eingeschaltet. Sobald eines der vorgenannten Schaltereignisse von dem entsprechenden Sicherheitsschaltgerät 10, 12, 14 erkannt wird, werden die zugehörigen Arbeitskontakte 22, 24 geöffnet. Dadurch fallen die Schütze 38, 40 ab und die Energieversorgung der Maschine 42 wird unterbrochen.

In DE 196 26 129 A1 ist ein weiterentwickeltes Sicherheitsschaltgerät beschrieben, bei dem die elektromechanischen Schaltelemente durch sogenannte MOSFETs, d.h. elektronische Schaltelemente ersetzt sind. Elektronische Schaltelemente arbeiten kontaktlos und unterliegen daher keinem mechanischen Verschleiß. Außerdem sind sie heutzutage kostengünstiger als Relais und sie benötigen weniger Platz. Trotz dieser Vorteile besteht jedoch ein Wunsch nach weiteren Verbesserungen.

Es ist eine Aufgabe der vorliegenden Erfindung, ein kostengünstiges und flexibel einsetzbares Sicherheitsschaltgerät der eingangs genannten Art anzugeben.

Diese Aufgabe wird durch ein Sicherheitsschaltgerät nach Anspruch 1 gelöst. "Im wesentlichen stationäre Ausgangssignale" sind dabei solche, die einem nachfolgenden, typgleichen Sicherheitsschaltgerät als stationär erscheinen. Dies schließt nicht aus, daß die Ausgangssignale trotzdem Signalveränderungen beinhalten können, die dann jedoch so kurz oder geringfügig sind, daß das nachfolgende Sicherheitsschaltgerät diese nicht erkennen kann. Die getakteten Ausgangssignale kann es dagegen als solche erkennen und gezielt auswerten. Mit dieser Maßnahme ist es auf einfache Weise möglich, einen Querschluß in der Verbindung zwischen zwei Sicherheitsschaltgeräten zu entdecken. Damit kann die (höchste) Sicherheitskategorie 4 der europäischen Norm EN 954-1 sehr einfach auch mit zusammengeschalteten Geräten erfüllt werden.

Das erfindungsgemäße Sicherheitsschaltgerät besitzt elektronische Schaltelemente und ist daher im Vergleich zu den herkömmlichen, kontaktbehafteten Sicherheitsschaltgeräten sehr kostengünstig und verschleißarm. Im Unterschied zu dem eingangs genannten Sicherheitsschaltgerät erzeugen die verwendeten Schaltelemente jedoch ein aktives Ausgangssignal mit wechselndem Potential. Dieses Ausgangssignal kann in nachfolgenden erfindungsgemäßen Sicherheitsschaltgeräten direkt weiterverarbeitet werden.

Ein Vorteil ist, daß die Anzahl der erforderlichen Ausgangsklemmen bei gleicher Anzahl an Schaltelementen reduziert werden kann, da anstelle eines Ausgangsklemmenpaares nur jeweils eine einzelne Ausgangsklemme benötigt wird. Dies spart Bauraum und Kosten für die mechanischen Anschlußklemmen.

Darüber hinaus ist das erfindungsgemäße Sicherheitsschaltgerät sehr flexibel. Es können nämlich aufgrund der Erfindung mehrere Sicherheitsschaltgeräte direkt in Reihe geschaltet werden, um eine logische Verknüpfung zu bilden. Dabei werden die Ausgangsklemmen eines erfindungsgemäßen Sicherheitsschaltgerätes mit den Eingangsklemmen eines nachfolgenden Sicherheitsschaltgerätes zu einem Sicherheitsschaltgeräte-System verbunden. Die Verschaltung erweitert die Anwendungssvielfalt und ermöglicht auf einfache Weise den Aufbau intelligenter, hierarchischer Sicherheitssteuerungen. Ein weiterer Vorteil der Erfindung ist die Möglichkeit, die Sicherheitsschaltgeräte in Reihe zu schalten, ohne daß aufwendige und teure Bauteile, wie Trafos, Optokoppler etc., zur Ansteuerung der Schaltelemente benötigt werden.

In einer Ausgestaltung der Erfindung beinhaltet jedes Schaltelement eine Reihenschaltung aus einem Transistor und zumindest einem Widerstand, wobei die Reihenschaltung von einer Versorgungsspannung des Sicherheitsschaltgerätes derart gespeist wird, daß der Ausgang des Schaltelements zwischen den beiden Potentialen der Versorgungsspannung schaltbar ist. Diese Ausbildung des Schaltelements hat sich in der Praxis als besonders vorteilhaft erwiesen. Insbesondere lassen sich so auf einfachem und direktem Weg aktive Ausgangssignale erzeugen, die zur Ansteuerung eines externen Aktors geeignet sind.

In einer weiteren Ausgestaltung der Erfindung weist das Sicherheitsschaltgerät eine logische Verknüpfungseinheit und zumindest eine weitere Eingangsklemme zum Zuführen zumindest eines weiteren Schaltsignals auf, wobei die Verknüpfungseinheit das zumindest eine weitere Schaltsignal mit dem ersten Schaltsignal zu einem kombinierten Schaltsignal logisch verknüpft.

Die logische Verknüpfung ist bevorzugt eine UND-Verknüpfung. Sie kann aber auch eine ODER-Verknüpfung sein, um auf einfache Weise beispielsweise einen Zustimmtaster mit einer Schutztürüberwachung zu kombinieren.

Die Maßnahme besitzt den Vorteil, daß das Sicherheitsschaltgerät besonders gut für die Anordnung in einer Reihenschaltung geeignet ist, da sich die Ausgangssignale eines vorhergehenden Sicherheitsschaltgerätes hier sehr einfach und fehlersicher mit dem eigentlichen eingangsseitigen Schaltsignal des nachfolgenden Sicherheitsschaltgerätes verknüpfen lassen. Die Einsatzmöglichkeiten des Sicherheitsschaltgerätes lassen sich damit deutlich steigern. Insbesondere kann auf sehr einfache Weise eine flexible, hierarchische Sicherheitssteuerung aufgebaut werden. Dabei werden verschiedene Aktoren, beispielsweise externe Schütze, von verschiedenen der zusammengeschalteten Sicherheitsschaltgeräte angesteuert. Die Auslösung eines Schaltereignisses bei einem Sicherheitsschaltgerät der Reihe hat dann ein entsprechendes Schaltereignis bei allen nachfolgenden, jedoch nicht notwendigerweise bei den vorhergehenden Sicherheitsschaltgeräten zur Folge. Ein solches hierarchisches Sicherheitsschaltgeräte-System ist vor allem dann von Vorteil, wenn das Abschalten eines bestimmten Maschinenabschnitts zu einem Abschalten von nachgeordneten Maschinenabschnitten, nicht aber von vorgelagerten Maschinenabschnitten führen soll. Bei einer hydraulischen Presse können so bspw. bei Auslösen eines Schaltsignals "ganz vorne" sämtliche Pumpen und Ventile abgeschaltet werden, während ein Schaltsignal "am Ende der Reihe" nur ein ganz bestimmtes Ventil abschaltet, die Pumpen und anderen Ventile jedoch eingeschaltet bleiben.

Die Bereitstellung von zwei zusätzlichen, speziellen (dedizierten) Eingängen hat dabei den Vorteil, daß das Sicherheitsschaltgeräte-System sehr leicht gemäß der höchsten Sicherheitskategorie 4 der europäischen Norm EN 954-1 aufgebaut werden kann. Die dem Sicherheitsschaltgerät unmittelbar zugeordneten Schaltsignale lassen sich zunächst auf einen Querschluß in den Anschlußleitungen überprüfen, bevor sie mit dem Ausgangssignal des vorhergehenden Sicherheitsschaltgerätes verknüpft werden.

In einer weiteren Ausgestaltung weist das Sicherheitsschaltgerät zumindest zwei weitere Ausgangsklemmen sowie einen Taktgenerator auf, der zwei unterschiedliche Taktsignale an den zwei weiteren Ausgangsklemmen bereitstellt.

Mit dieser Maßnahme können passive Signalgeber, wie beispielsweise kontaktbehaftete Not-Aus-Schalter, sehr einfach fehlersicher ausgewertet werden, und zwar auch dann, wenn die Signalgeber im Betrieb nur sehr selten betätigt werden.

In einer weiteren Ausgestaltung weist das Sicherheitsschaltgerät eine abschaltbare Querschlußüberwachung für die ersten und zweiten Ausgangsklemmen auf.

Diese Maßnahme ermöglicht es, die Ausgangsklemmen in einer nachfolgend erläuterten Weise zusammenzuführen, um so eine Stromverstärkung zu erzielen. Damit ist es möglich, beispielsweise eine SPS-Karte direkt anzusteuern und zu versorgen.

In einer weiteren Ausgestaltung weist das Sicherheitsschaltgerät zumindest ein erstes und ein zweites komplementäres Schaltelement auf, deren Ausgänge mit jeweils einer komplementären Ausgangsklemme des Schaltgerätes verbunden sind.

Damit können in einer sicherheitskritischen Anwendung auf einfache Weise komplemetäre und damit redundante Abschaltwege aufgebaut werden, wodurch die Fehlersicherheit insgesamt nochmals erhöht wird.

Es versteht sich, daß die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Ansprüche zu verlassen.

Ausführungsbeispiele der Erfindung sind in der Zeichnung dargestellt und werden in der nachfolgenden Beschreibung näher erläutert. Es zeigen:
- Fig. 1: eine schematische Darstellung eines Sicherheitsschaltgeräte-Systems gemäß dem Stand der Technik;
- Fig. 2: eine schematische Darstellung eines Sicherheitsschaltgerätes;
- Fig. 3: eine schematische Darstellung einer Reihenschaltung aus zwei Sicherheitsschaltgeräten gemäß Fig. 2;
- Fig. 4: eine schematische Darstellung einer Reihenschaltung aus einem Sicherheitsschaltgerät gemäß Fig. 2 und einem weiteren Sicherheitsschaltgerät gemäß einem weiteren Ausführungsbeispiel;
- Fig. 5: das in Fig. 4 gezeigte Sicherheitsschaltgeräte-System mit einem weiteren Aktor;
- Fig. 6: eine schematische Darstellung einer Reihenschaltung aus zwei Sicherheitsschaltgeräten gemäß einem weiteren Ausführungsbeispiel;
- Fig. 7: eine schematische Darstellung eines Sicherheitsschaltgerätes gemäß einem weiteren Ausführungsbeispiel; und
- Fig. 8: eine schematische Darstellung eines Sicherheitsschaltgerätes gemäß einem weiteren Ausführungsbeispiel.

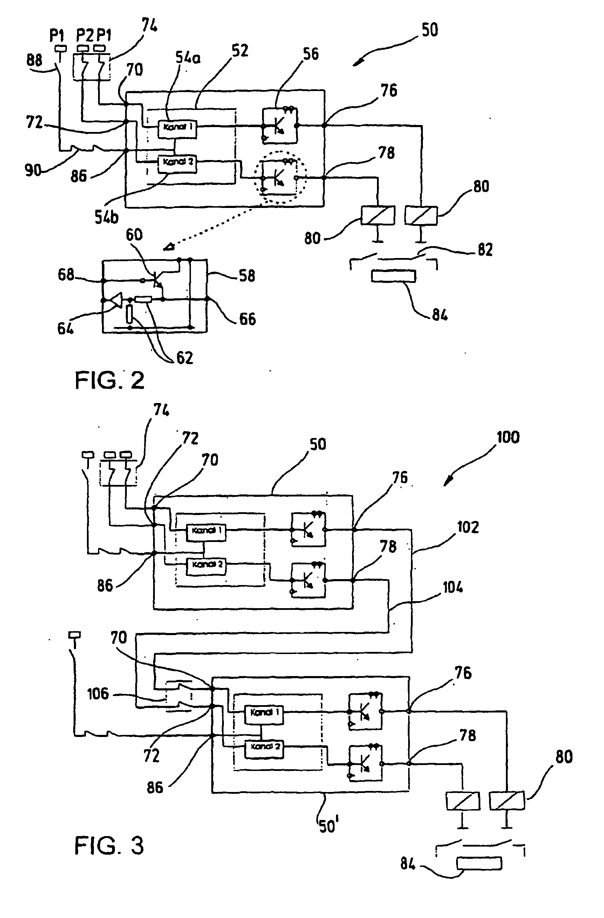

In Fig. 2 ist ein Sicherheitsschaltgerät in seiner Gesamtheit mit dem Bezugszeichen 50 bezeichnet. Das Sicherheitsschaltgerät 50 weist eine hier nur schematisch angedeutete sichere Auswerte- und Steuereinheit 52 auf. Die Auswerte- und Steuereinheit 52 ist aus an sich bekannten Bauelementen aufgebaut, wie sie beispielsweise in Sicherheitsschaltgeräten des Typs "PNOZ" der Anmelderin verwendet werden. Die Aufgabe der Auswerte- und Steuereinheit 52 besteht darin, eingangsseitig zugeführte Schaltsignale fehlersicher auszuwerten und entsprechende Ausgangssignale zu erzeugen.

Die Auswerte- und Steuereinheit 52 ist im gezeigten Ausführungsbeispiel zweikanalig aufgebaut, wobei die beiden Kanäle mit den Bezugszeichen 54a und 54b gekennzeichnet sind. Es sind aber auch andere Ausgestaltungen der Auswerte- und Steuereinheit 52 möglich. Zur näheren Erläuterung wird beispielsweise auf das Buch "Maschinensicherheit", Winfried Gräf, Hüthig Verlag, 1997, Bezug genommen.

Das Sicherheitsschaltgerät 50 besitzt ferner Schaltelemente 56, 58, die von der Auswerte- und Steuereinheit 52 Steuersignale erhalten. Bei den Schaltelementen 56, 58 handelt es sich im einfachsten Fall um jeweils einen Transistor, dessen Basis das Steuersignal empfängt und an dessen Emitter oder Kollektor ein Ausgangssignal abgegriffen wird, wobei das Ausgangssignal von dem Schaltelement auf zwei unterschiedliche Potentiale schaltbar ist.

Im vorliegenden Ausführungsbeispiel besitzen die Schaltelemente 56, 58 neben einem Transistor 60 jeweils zwei in Reihe geschaltete Widerstände 62 sowie einen Verstärker 64. Der Kollektor des Transistors 60 liegt an einem ersten Bezugspotential UB, während der Emitter des Transistors 60 über die Reihenschaltung der Widerstände 62 an einem zweiten Potential (Masse) liegt. Der Verstärker 64 ist mit seiner Eingangsseite mit dem Knoten der beiden Widerstände 62 verbunden und stellt an seinem Ausgang ein Rückkoppelsignal zur Verfügung.

Das Ausgangssignal jedes Schaltelements 56, 58 wird am Emitter des Transistors 60 abgenommen und steht an einem Ausgang 66 zur Verfügung. Ferner gelangt das Ausgangssignal der Auswerte- und Steuereinheit 52 über einen Eingang 68 an die Basis des Transistors 60.

Jedes Schaltelement 56, 58 ist so aufgebaut, daß abhängig von dem Signal am Eingang 68 das am Ausgang 66 anliegende Signal zwischen dem ersten Potential und dem zweiten Potential geschaltet wird. Im vorliegenden Ausführungsbeispiel liegt am Ausgang 66 das erste Potential UB an, wenn das Eingangssignal am Eingang 68 in etwa dasselbe Potential hat. Wenn das Eingangssignal nahe am zweiten Potential liegt, ist auch das Ausgangssignal am Ausgang 66 auf dem zweiten Potential.

Das in Fig. 2 gezeigte Sicherheitsschaltgerät 50 besitzt zwei Eingangsklemmen 70, 72, die jeweils mit der Auswerte- und Steuereinheit 52 verbunden sind. An diese beiden Eingangsklemmen 70, 72 wird - im vorliegenden Ausführungsbeipiel - ein zweikanaliger Schalter 74 angeschlossen, und zwar derart, daß die Eingangsklemme 70 bei geschlossenem Schalter mit einem Potential P1 und die Eingangsklemme 72 mit einem Potential P2 verbunden sind. Bei dem Schalter 74 handelt es sich beispielsweise um einen Not-Aus-Schalter einer Maschine oder einer Schutztür.

Je nach gewünschter Sicherheitskategorie sind die beiden Potentiale P1 und P2 gleich (Kategorie 3) oder ungleich (Kategorie 4). Letzteres kann auch dadurch erreicht werden, daß die Potentiale P1 und P2 unterschiedlich getaktet sind.

Das Sicherheitsschaltgerät 50 besitzt ferner Ausgangsklemmen 76, 78, wobei jede Ausgangsklemme mit dem Ausgang 66 jeweils eines Schaltelements 56, 58 verbunden ist. Somit ist jeder Ausgangsklemme ein Schaltelement zugeordnet, wobei das Ausgangssignal des Schaltelements über die entsprechende Ausgangsklemme von außen abgreifbar ist.

An die Ausgangsklemmen 76, 78 ist jeweils ein Aktor 80, beispielsweise ein Relais oder ein Schütz angeschlossen. Die Arbeitskontakte 82 der beiden Relais 80 liegen in Reihe und dienen zum Schließen oder Öffnen einer Energieversorgungsleitung zu einer nur schematisch angedeuteten Maschine 84. Die Maschine 84 läuft im vorliegenden Ausführungsbeispiel nur dann, wenn beide Arbeitskontakte 82 geschlossen sind, wenn also an beiden Ausgangsklemmen 76, 78 ein zur Aktivierung der Relais 80 ausreichendes Signal anliegt.

Das Sicherheitsschaltgerät 50 weist eine weitere Eingangsklemme 86 auf, an der ein Startsignal zuführbar ist. Dieses Startsignal wird von einem Startschalter 88 erzeugt, indem eine Verbindung zu einem Potential P1 geschaffen wird. In Reihe zu dem Startschalter 88 liegen zwei weitere Arbeitskontakte 90 der Relais 80, die mit den Arbeitskontakten 82 zwangsgeführt sind, jedoch im Gegensatz zu diesen als Öffner ausgebildet sind. Damit wird erreicht, daß die Eingangsklemme 86 auf jeden Fall dann vom Potential P1 getrennt wird, wenn zumindest einer der beiden Arbeitskontakte 82 geschlossen ist.

Das Sicherheitsschaltgerät 50 hat die Aufgabe, die Arbeitskontakte 82 zu schließen, wenn ein Startsignal an der Eingangsklemme 86 anliegt. Die Maschine 84 läuft daraufhin an. Wenn bei Eintreten eines Notfalls der Not-Aus-Schalter 74 gedrückt wird, wertet die Auswerte- und Steuereinheit 52 dieses Schaltereignis aus und steuert die Schaltelemente 56, 58 entsprechend an. Die Ausgangssignale werden auf das zweite Potential (Masse) gebracht, so daß die Bestromung der beiden Relais 80 unterbrochen wird. Dies führt dazu, daß die beiden Arbeitskontakte 82 öffnen und die Maschine 84 zum Stillstand kommt. Die Auswerte- und Steuereinheit 52 arbeitet dabei fehlersicher im Sinne europäischer Sicherheitsnormen, so daß beispielsweise verschweißte Arbeitskontakte der Relais 80 oder ein Querschluß zwischen den beiden Eingangsklemmen 70, 72 erkannt wird. Ferner läßt sich über das Rückkoppelsignal ein Fehler des Schaltelements 56, 58 erkennen.

In Fig. 3 ist ein Sicherheitsschaltgeräte-System 100 dargestellt, das zwei Sicherheitsschaltgeräte 50, 50' umfaßt.

Die beiden Sicherheitsschaltgeräte 50, 50' sind über zwei Leitungen 102, 104 miteinander verbunden, wobei die beiden Leitungen 102, 104 an ihrem einen Ende an den Ausgangsklemmen 76, 78 des Sicherheitsschaltgerätes 50 und an ihrem anderen Ende an den Eingangsklemmen 70, 72 des Sicherheitsschaltgerätes 50' angeschlossen sind. In den Leitungen 102, 104 ist ein zweikanaliger Schalter 106, beispielsweise ein Not-Aus-Schalter angeordnet, der bei Betätigung die elektrische Verbindung zwischen den Sicherheitsschaltgeräten 50, 50' unterbricht.

Die Eingangsklemmen 70, 72, 86 des ersten Sicherheitsschaltgerätes 50 sind so beschaltet wie in Fig. 2. Ferner ist die Eingangsklemmen 86 des Sicherheitsschaltgerätes 50' so verschaltet wie in Fig. 2 dargestellt. An den Ausgangsklemmen 76, 78 des zweiten Sicherheitsschaltgerätes 50' sind die Relais 80 angeschlossen, um die Maschine 84 zu steuern.

Die beiden Sicherheitsschaltgeräte 50, 50' sind damit so miteinander verknüpft, daß die Betätigung eines der beiden Schalter 74, 106 genügt, um die Arbeitskontakte 82 der Relais 80 zu öffnen und die Maschine 84 zum Stillstand zu bringen.

Da die beiden Eingangsklemmen 70, 72 des zweiten Sicherheitsschaltgerätes 50' auf gleichem Potential liegen, ist ein Querschluß zwischen den beiden Leitungen 102, 104 nicht zu erkennen, so daß dieses System nur der Sicherheitskategorie 3 entspricht.

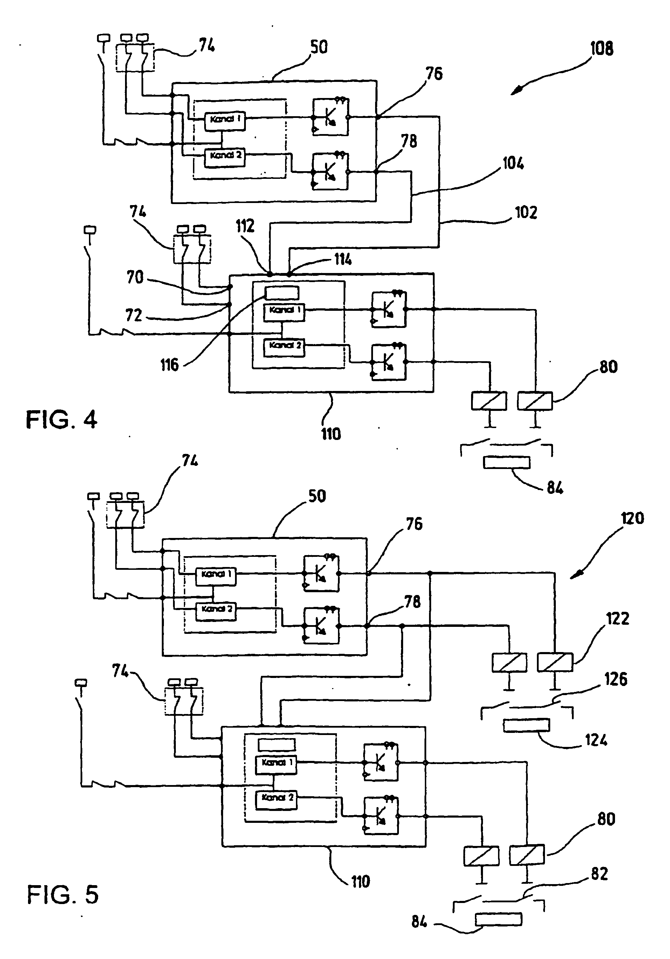

Um die Sicherheitskategorie 4 zu erreichen, ist in Fig. 4 ein weiteres Ausführungsbeispiel eines Sicherheitsschaltgeräte-Systems 108 dargestellt. Hinsichtlich seines Aufbaus entspricht es im wesentlichen dem mit Bezug auf die Fig. 3 erläuterten Sicherheitsschaltgeräte-System 100. Der Unterschied besteht in dem Aufbau des zweiten Sicherheitsschaltgerätes 110. Dieses verfügt zusätzlich zu den beiden Eingangsklemmen 70, 72 über zwei weitere Eingangsklemmen 112, 114, die als dedizierte Eingänge dienen. Die Eingangsklemmen 112, 114 sind über Leitungen 102, 104 mit den Ausgangsklemmen 76, 78 des ersten Sicherheitsschaltgerätes 50 verbunden.

Die beiden Eingangsklemmen 70, 72 des zweiten Sicherheitsschaltgerätes 110 sind mit einem Schalter 74 verbunden, der eine Verbindung zu Potentialen P1 und P2 ermöglicht. Werden die beiden Potentiale P1, P2 ungleich gewählt, läßt sich ein Querschluß zwischen den beiden Eingangsklemmen 70, 72 erkennen. Ein Querschluß zwischen den beiden Leitungen 102, 104 läßt sich über die Rückkoppelsignale der Schaltelemente 56, 58 des ersten Sicherheitsschaltgerätes 50 feststellen. Somit wird Sicherheitskategorie 4 erreicht.

Um die gleiche Funktion wie das Sicherheitsschaltgeräte-System 100 zu realisieren, besitzt die Auswerte- und Steuereinheit 52 des Sicherheitsschaltgerätes 110 eine Verknüpfungseinheit 116. Der Verknüpfungseinheit 116 werden die an den zusätzlichen Eingangsklemmen 112, 114 anliegenden Signale zugeführt. Die Funktion der Verknüpfungseinheit 116 besteht darin, ein Abschalten der Bestromung der Relais 80 über die Schaltelemente 56, 58 auch dann herbeizuführen, wenn der dem ersten Sicherheitsschaltgerät 50 zugeordnete Schalter 74 betätigt wird. Eine mögliche Realisierung dieser Funktion besteht darin, die an den Eingangsklemmen 70 und 112 bzw. den Eingangsklemmen 72 und 114 anliegenden Signale jeweils zu einem kombinierten Schaltsignal UND-zu verknüpfen, wobei die beiden resultierenden kombinierten Schaltsignale dann so verarbeitet werden, wie bei dem Sicherheitsschaltgerät 50 die an den Eingangsklemmen 70, 72 anliegenden Eingangssignale. Durch die Verknüpfungseinheit 116 werden die Signale an den Eingangsklemmen 70 und 112 bzw. 72 und 114 bereits miteinander verknüpft, bevor ein Signal am Ausgang des Sicherheitsschaltgerätes erzeugt wird.

Die logische Verknüpfung kann grundsätzlich in an sich bekannter Weise mit Hilfe einer digitalen Logikschaltung "festverdrahtet" realisiert sein. Bei einer elektronischen Realisierung der Auswerte- und Steuereinheit 52 ist die logische Verknüpfung bevorzugt mit einem Mikroprozessor und geeignete Herstellerprogrammierung oder durch ein entsprechendes ASIC implementiert. In weiteren Ausführungsbeispielen sind alternative logische Verknüpfungen möglich, beispielsweise eine UND- und alternativ eine ODER-Verknüpfung. Die gewünschte Art der Verknüpfung kann über eine Schnittstelle (V24, USB, Infrarot oder ähnliches) in einen internen Speicher des Sicherheitsschaltgerätes übertragen werden. In einem weiteren Ausführungsbeispiel kann die gewünschte Verknüpfung über eine auswechselbare Chipkarte bestimmt werden.

Bei einer ODER-Verknüpfung wird bevorzugt eine zusätzliche Kennung erzeugt und an einem Ausgang bereitgestellt, die dazu verwendet werden kann, bei einer zu steuernden Maschine eine nur begrenzte Drehzahl zuzulassen.

In Fig. 5 ist ein weiteres Ausführungsbeispiel eines Sicherheitsschaltgeräte-Systems gezeigt und mit dem Bezugszeichen 120 gekennzeichnet. Das Sicherheitsschaltgeräte-System 120 entspricht im wesentlichen dem aus Fig. 4. Aus diesem Grund wird auf eine detaillierte Erläuterung der mit den gleichen Bezugszeichen gekennzeichneten Teile verzichtet.

Der Unterschied zu dem in Fig. 4 gezeigten Sicherheitsschaltgeräte-System 108 liegt darin, daß zwei weitere Relais 122 oder allgemein Aktoren vorgesehen sind, die die Energieversorgung zu einer Maschine oder einem Maschinenabschnitt 124 ein- und ausschalten können. Jedes der beiden Relais 122 verfügt über Arbeitskontakte 126. Eines der Relais 122 ist mit der Ausgangsklemme 76 und das andere mit der Ausgangsklemme 78 des ersten Schaltgeräts 50 verbunden. Die Arbeitskontakte 126 werden damit abhängig von den an den Ausgangsklemmen 76, 78 des ersten Sicherheitsschaltgerätes 50 anliegenden Signale betätigt.

Die Verbindung zwischen den ersten und zweiten Ausgangsklemmen des einen Sicherheitsschaltgerätes und den Eingangsklemmen des nachfolgenden Sicherheitsschaltgerätes beinhalten hiernach also zumindest einen Aktor.

Insgesamt ergibt sich hier ein hierarchisch aufgebautes Sicherheitsschaltgeräte-System, das abhängig von der Position eines einzelnen Sicherheitsschaltgerätes innerhalb der Reihenschaltung ein oder mehrere Relais 80, 122 abschaltet. Beispielsweise schalten die Relais 80 die Ventile (hier nicht dargestellt) und die Relais 122 die Pumpe (ebenfalls nicht dargestellt) einer hydraulischen Presse.

Im vorliegenden Ausführungsbeispiel führt die Betätigung des dem ersten Sicherheitsschaltgerät 50 zugeordneten Schalters 74 sowohl zu einem Öffnen der Arbeitskontakte 126 der Relais 122 als auch der Arbeitskontakte 82 der Relais 80. Damit werden beide Maschinenabschnitte (Ventile und Pumpe) 84, 124 zum Stillstand gebracht. Wird jedoch der dem zweiten Sicherheitsschaltgerät 110 zugeordnete Schalter 74 betätigt, führt dies nur zu einem Öffnen der Arbeitskontakte 82 und damit zum Stillstand des Maschinenabschnitts 84 (Ventile). Der Maschinenabschnitt 124 (Pumpe) bleibt von diesem Schaltereignis unberührt.

Allgemein läßt sich die Funktion dieses hierarchischen Sicherheitsschaltgeräte-Systems 120 so beschreiben, daß die Betätigung eines Schalters zwar nicht auf die vorhergehenden, aber auf die nachfolgenden Sicherheitsschaltgeräte Einfluß hat.

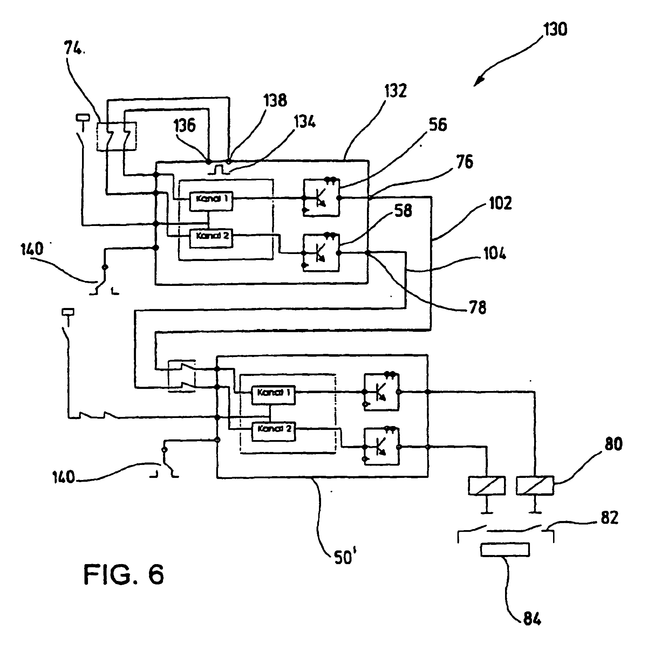

In Fig. 6 ist ein weiteres Ausführungsbeispiel eines Sicherheitsschaltgeräte-Systems gezeigt und mit dem Bezugszeichen 130 gekennzeichnet. Das Sicherheitsschaltgeräte-System 130 entspricht im wesentlichen dem in Fig. 3 gezeigten Sicherheitsschaltgeräte-System 100. Auf eine nochmalige Beschreibung der mit gleichen Bezugszeichen gekennzeichneten Teile wird aus diesem Grund verzichtet.

Der Unterschied zu dem Sicherheitsschaltgeräte-System 100 ist in der Ausgestaltung des Sicherheitsschaltgerätes 132 zu sehen. Wie bereits zuvor erwähnt, wird der Schalter 74 des ersten Sicherheitsschaltgerätes 132 mit zwei unterschiedlichen Potentialen P1 und P2 beaufschlagt, um die Sicherheitskategorie 4 zu erreichen. Statt der Beaufschlagung mit zwei unterschiedlichen Potentialen ist es jedoch auch möglich, den Schalter 74 mit zwei unterschiedlichen, beispielsweise phasenverschobenen, Taktsignalen zu beaufschlagen, die bei geschlossenem Schalter 74 an die Eingangsklemmen 70, 72 zurückgeführt werden. Die beiden unterschiedlichen Taktsignale werden von einem Taktgenerator 134 im Sicherheitsschaltgerät 132 erzeugt und liegen an zwei weiteren Ausgangsklemmen 136, 138 an. Von dort werden sie über elektrische Verbindungen zu dem Schalter 74 geführt. Die Auswerte- und Steuereinheit 52 erfaßt nun diese beiden Taktsignale über die Eingangsklemmen 70, 72 und vergleicht sie mit den an den Ausgangsklemmen 136, 138 anliegenden Originalsignalen. Werden Abweichungen detektiert, deutet es entweder auf das Betätigen des Schalters 74 oder auf einen Fehler in den Signalleitungen hin. Die Auswerte- und Steuereinheit 52 wird daraufhin die Schaltelemente 56, 58 entsprechend ansteuern, so daß die Arbeitskontakte 82 der Relais 80 über das zweite Sicherheitsschaltgerät 50' geöffnet werden und die Maschine 84 zum Stillstand kommt.

Um auch Fehler in den beiden Leitungen 102, 104 zwischen den beiden Sicherheitsschaltgeräten 132, 50' zu erkennen, werden diese Leitungen ebenfalls mit einem Taktsignal beaufschlagt. Daher werden die Schaltelemente 56, 58 des ersten Sicherheitsschaltgerätes 132 hier im Takt betrieben, so daß das entsprechende Taktsignal an den Ausgangsklemmen 76, 78 anliegt.

Da ein solches Taktsignal nicht dazu geeignet ist, ein Relais 80 anzusteuern, läßt sich das Sicherheitsschaltgerät 132 bzw. 50' über einen Schalter 140 zwischen einem ersten Betriebsmodus (Normalmodus) und einem zweiten Betriebsmodus (Taktmodus) umschalten. Im Normalmodus liegt an den Ausgangsklemmen 76, 78 ein zur Ansteuerung eines Relais geeignetes Signal an, während im Taktmodus an den Ausgangsklemmen 76, 78 Taktsignale anliegen, die von einem nachgeordneten Sicherheitsschaltgerät verarbeitet werden können.

Im vorliegenden Ausführungsbeispiel wird das Sicherheitschaltgerät 132 im Taktmodus und das Sicherheitsschaltgerät 50' im Normalmodus betrieben, da letzteres zur Ansteuerung der Relais 80 vorgesehen ist.

Mit Bezug auf die Fig. 3 bis 6 wurden Ausführungsbeispiele eines Sicherheitsschaltgeräte-Systems dargestellt, wobei aus Übersichtlichkeitsgründen die einzelnen Systeme lediglich zwei Sicherheitsschaltgeräte umfassen. Es versteht sich, daß die Anzahl der in Reihe geschalteten Sicherheitsschaltgeräte beliebig größer gewählt werden kann. Einzig und allein die Schaltverzögerungszeit des gesamten Systems setzt der wählbaren Anzahl Grenzen. Diese Grenze liegt bedingt durch die sehr geringe Schaltverzögerungszeit der eingesetzten Schaltelemente 56, 58 deutlich höher als bei einem System, wie es in Fig. 1 gezeigt ist.

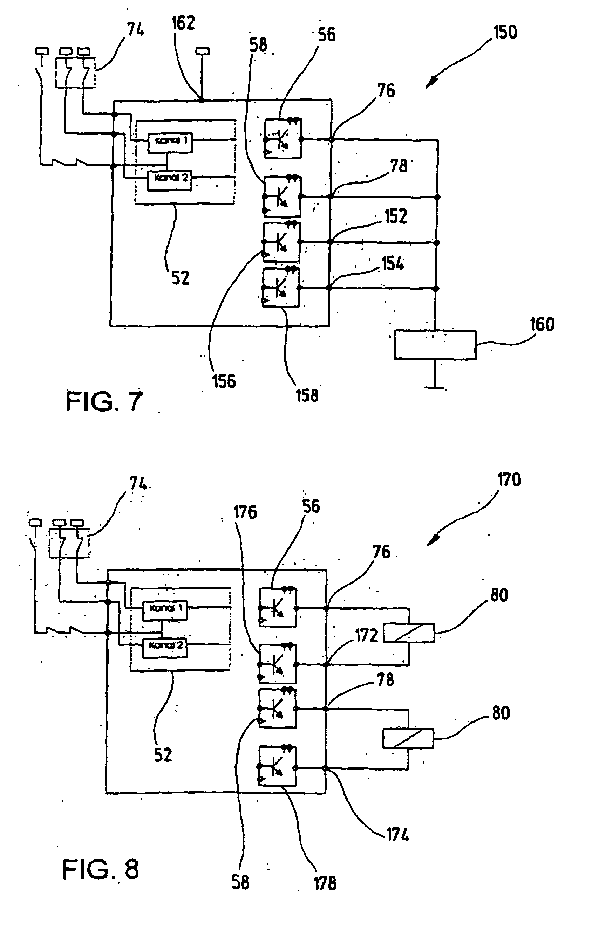

In Fig. 7 ist ein weiteres Ausführungsbeispiel eines Sicherheitsschaltgerätes gezeigt und mit dem Bezugszeichen 150 gekennzeichnet. Das Sicherheitsschaltgerät 150 entspricht im wesentlichen dem in Fig. 2 dargestellten Sicherheitsschaltgerät 50, so daß auf eine Beschreibung der mit gleichen Bezugszeichen gekennzeichneten Teile verzichtet wird. Im Unterschied zu dem Sicherheitsschaltgerät 50 gemäß Fig. 2 besitzt das Sicherheitsschaltgerät 150 jedoch weitere Ausgangsklemmen 152, 154, die zusätzlich zu den Ausgangsklemmen 76, 78 vorhanden sind. Jede der Ausgangsklemmen 76, 78, 152, 154 ist mit dem Ausgang eines Schaltelements 56, 58, 156, 158 verbunden, die ihr Steuersignal jeweils von der Auswerte- und Steuereinheit 52 erhalten.

Die an den Ausgahgsklemmen 76, 78, 152, 154 anliegenden Signale werden zusammengeführt und dienen zur Versorgung beispielsweise einer SPS-Karte 160. Durch Zusammenführen der Signale läßt sich eine Stromverstärkung erzielen.

Um zu vermeiden, daß die Zusammenführung der Ausgänge als Kurzschluß von der Auswerte- und Steuereinheit 52 über die Auswertung der Rückkoppelsignale detektiert wird, läßt sich diese Auswertung bei dem Sicherheitsschaltgerät 150 durch Anlegen eines definierten Signals an einer Steuereingangsklemme 162 unterdrücken.

In Fig. 8 ist ein weiteres Ausführungsbeispiel eines Sicherheitsschaltgerätes dargestellt und mit dem Bezugszeichen 170 gekennzeichnet. Das Sicherheitsschaltgerät 170 entspricht im wesentlichen dem mit Bezug auf die Fig. 2 beschriebenen Sicherheitsschaltgerät 50. Der Unterschied liegt darin, daß die Ausgänge zweipolig ausgestaltet sind. D.h., daß zu jeder Ausgangsklemme 76, 78 eine zugeordnete komplementäre Ausgangsklemme 172 bzw. 174 vorgesehen ist. Den beiden komplementären Ausgangsklemmen 172, 174 ist jeweils ein komplementäres Schaltelement 176, 178 zugeordnet. Um eine Bestromung des an einem Ausgangsklemmenpaar 76, 172 bzw. 78, 174 angeschlossenen Relais 80 zu erreichen, sind die jeweiligen Schaltelemente-Paare 56, 176 bzw. 58, 178 komplementär zueinander ausgelegt. Beim Einschalten beider Schaltelemente 56, 176 bzw. 58, 178 werden die Ausgangsklemmen 76 bzw. 78 auf ein erstes Potential und die Ausgangsklemmen 172 bzw. 174 auf ein zweites Potential gelegt, wobei die beiden Potentiale ungleich sind.

Diese zweipolige Ausgestaltung hat den Vorteil, daß zusätzliche Abschaltwege für die Relais 80 zur Verfügung stehen, so daß die Fehlersicherheit des Sicherheitsschaltgerätes 170 erhöht ist.

Es versteht sich, daß das Sicherheitsschaltgerät 170 auch in den zuvor beschriebenen Sicherheitsschaltgeräte-Systemen zum Einsatz kommen kann.

## Patentansprüche

1. Sicherheitsschaltgerät zum Ein- und sicheren Ausschalten eines elektrischen Verbrauchers (84, 124), insbesondere einer elektrisch angetriebenen Maschine, mit zumindest einem ersten und einem zweiten elektronischen Schaltelement (56, 58; 56, 58, 156, 158; 56, 58, 176, 178), zumindest einer ersten und einer zweiten Ausgangsklemme (76, 78; 76, 78, 152, 154; 76, 78, 172, 174) sowie zumindest einer Eingangsklemme (70, 72) für ein erstes Schaltsignal, das auf die Schaltelemente (56, 58; 56, 58, 156, 158; 56, 58, 176, 178) einwirkt, wobei das erste und das zweite Schaltelement (56, 58; 56, 58, 156, 158; 56, 58, 176, 178) jeweils einen Ausgang (66) aufweisen, der in Abhängigkeit von dem ersten Schaltsignal ein Ausgangssignal eines ersten (UB) oder eines zweiten Potentials (Masse) bereitstellt, wobei der Ausgang (66) des ersten Schaltelements (56; 56, 156; 56, 176) mit der ersten Ausgangsklemme (76; 76, 152; 76, 172) und der Ausgang (66) des zweiten Schaltelements (58; 58, 158; 58, 178) mit der zweiten Ausgangsklemme (78; 78, 154; 78, 174) verbunden ist, **gekennzeichnet durch** ein Betriebsmodus-Wahlmittel (140), das die Wahl zwischen zumindest einem ersten und einem zweiten Betriebsmodus ermöglicht, wobei die Schaltelemente (56, 58) in dem ersten Betriebsmodus im wesentlichen stationäre Ausgangssignale und in dem zweiten Betriebsmodus getaktete Ausgangssignale liefern, wobei die im wesentlichen stationären Ausgangssignale solche sind, die einem nachfolgenden typgleichen Sicherheitsschaltgerät (50') als stationär erscheinen, und wobei das nachfolgende Sicherheitsschaltgerät (50') die getakteten Ausgangssignale erkennen und gezielt auswerten kann, um einen Querschluß in der Verbindung zu der ersten und Zweiten Ausgangsklemme zu entdecken, wobei die getakteten Ausgangssignale nicht dazu geeignet sind, ein Relais anzusteuern.

2. Sicherheitsschaltgerät nach Anspruch 1, **dadurch gekennzeichnet, daß** jedes Schaltelement (56, 58) eine Reihenschaltung aus einem Transistor (60) und zumindest einem Widerstand (62) beinhaltet, wobei die Reihenschaltung von einer Versorgungsspannung (UB; Masse) des Sicherheitsschaltgerätes derart gespeist wird, daß der Ausgang (66) des Schaltelements (56, 58) zwischen den beiden Potentialen (UB; Masse) der Versorgungsspannung schaltbar ist.

3. Sicherheitsschaltgerät nach Anspruch 1 oder 2, **dadurch gekennzeichnet, daß** es eine logische Verknüpfungseinheit (116) und zumindest eine weitere Eingangsklemme (112, 114) zum Zuführen zumindest eines weiteren Schaltsignals aufweist, wobei die Verknüpfungseinheit (116) das zumindest eine weitere Schaltsignal mit dem ersten Schaltsignal zu einem kombinierten Schaltsignal logisch verknüpft.

4. Sicherheitsschaltgerät nach Anspruch 3, **dadurch gekennzeichnet, daß** die Verknüpfungseinheit (116) die Schaltsignale logisch UND-verknüpft.

5. Sicherheitsschaltgerät nach einem der vorhergehenden Ansprüche, **dadurch gekennzeichnet, daß** es zumindest zwei weitere Ausgangsklemmen (136, 138) sowie einen Taktgenerator (134) aufweist, der zwei unterschiedliche Taktsignale an den zwei weiteren Ausgangsklemmen (136, 138) bereitstellt.

6. Sicherheitsschaltgerät nach einem der vorhergehenden Ansprüche, **dadurch gekennzeichnet, daß** es eine abschaltbare Querschlußüberwachung (162) für die ersten und zweiten Ausgangsklemmen (76, 78, 152, 154) aufweist.

7. Sicherheitsschaltgerät nach einem der vorhergehenden Ansprüche, **dadurch gekennzeichnet, daß** es zumindest ein erstes und ein zweites komplementäres Schaltelement (176, 178) aufweist, deren Ausgänge mit jeweils einer komplementären Ausgangsklemme (172, 174) des Schaltgerätes verbunden sind.

8. Sicherheitsschaltgeräte-System mit zumindest zwei Sicherheitsschaltgeräten (50, 50'; 50, 110; 132, 50') nach einem der vorhergehenden Ansprüche, **dadurch gekennzeichnet, daß** die zumindest zwei Sicherheitsschaltgeräte derart in Reihe geschaltet sind, daß die ersten und zweiten Ausgangsklemmen (76, 78) eines Sicherheitsschaltgerätes (50; 132) mit den Eingangsklemmen (70, 72) des nachfolgenden Sicherheitsschaltgerätes (50'; 110) verbunden sind.

9. Sicherheitsschaltgeräte-System nach Anspruch 8, **dadurch gekennzeichnet, daß** die Verbindung (102, 104) zwischen den ersten und zweiten Ausgangsklemmen (76, 78) des einen Sicherheitsschaltgerätes (50) und den Eingangsklemmen (70, 72) des nachfolgenden Sicherheitsschaltgerätes (50') zumindest einen Schalter (106) beinhaltet.

10. Sicherheitsschaltgeräte-System nach Anspruch 8 oder 9, **dadurch gekennzeichnet, daß** die Verbindung (102, 104) zwischen den ersten und zweiten Ausgangsklemmen (76, 78) des einen Sicherheitsschaltgerätes (50) und den Eingangsklemmen (70, 72) des nachfolgenden Sicherheitsschaltgerätes (110) zumindest einen Aktor (122) beinhaltet.

## Claims

1. A safety switching device for connecting and safely disconnecting an electrical load (84, 124), in particular an electrically driven machine, having at least a first and a second electronic switching element (56, 58; 56, 58, 156, 158; 56, 58, 176, 178), at least a first and a second output terminal (76, 78; 76, 78, 152, 154; 76, 78, 172, 174) and at least one input terminal (70, 72) for a first switching signal, which acts on the switching elements (56, 58; 56, 58, 156, 158; 56, 58, 176, 178), wherein the first and the second switching element (56, 58; 56, 58, 156, 158; 56, 58, 176, 178) each have an output (66) which provides an output signal at a first potential (UB) or at a second potential (ground) depending on the first switching signal, with the output (66) of the first switching element (56; 56, 156; 56, 176) being connected to the first output terminal (76; 76, 152; 76, 172), and the output (66) of the second switching element (58; 58, 158; 58, 178) being connected to the second output terminal (78; 78, 154; 78, 174), **characterized by** an operating mode selection means (140), which allows to choose between at least a first and a second operating mode, with the switching elements (56, 58) supplying substantially steady-state output signals in the first operating mode, and supplying pulsed output signals in the second operating mode, wherein the substantially steady-state output signals are signals which appear steady-state to a downstream safety switching device (50') of the same type, and wherein the downstream safety switching device (50') can detect and specifically evaluate the pulsed output signals in order to detect a cross connection in the wiring to the first and second output terminal, with the pulsed output signals not being suited to drive a relay.

2. The safety switching device as claimed in claim 1, **characterized in that** each switching element (56, 58) includes a series circuit formed by a transistor (60) and at least one resistor (62), with the series circuit being fed from a supply voltage (UB; ground) for the safety switching device such that the output (66) of the switching element (56, 58) can be switched between the two potentials (UB; ground) of the supply voltage.

3. The safety switching device as claimed in claim 1 or 2, **characterized by** comprising a logic interconnection unit (116) and at least one further input terminal (112, 114) for supplying at least one further switching signal, with the logic interconnection unit (116) logically interconnecting the at least one further switching signal and the first switching signal to form a combined switching signal.

4. The safety switching device as claimed in claim 3, **characterized in that** the logic interconnection unit (116) logically AND-interconnects the switching signals.

5. The safety switching device as claimed in any of the preceding claims, **characterized by** comprising at least two further output terminals (136, 138) and a clock generator (134), which produces two different clock signals at the two further output terminals (136, 138).

6. The safety switching device as claimed in any of the preceding claims, **characterized by** comprising a cross-connection monitoring member (162) for the first and second output terminals (76, 78, 152, 154), which cross-connection monitoring member (162) can be disabled.

7. The safety switching device as claimed in any of the preceding claims, **characterized by** comprising at least a first and a second complementary switching element (176, 178), whose outputs are respectively connected to complementary output terminals (172, 174) of the switching device.

8. A system of safety switching devices having at least two safety switching devices (50, 50'; 50, 110; 132, 50') as claimed in any of the preceding claims, **characterized in that** the at least two safety switching devices are connected in series such that the first and second output terminals (76, 78) of one safety switching device (50; 132) are connected to the input terminals (70, 72) of the downstream safety switching device (50'; 110).

9. The system of safety switching devices as claimed in claim 8, **characterized in that** the connection (102, 104) between the first and second output terminals (76, 78) of said one safety switching device (50) and the input terminals (70, 72) of the downstream safety switching device (50') includes at least one switch (106).

10. The system of safety switching devices as claimed in claim 8 or 9, **characterized in that** the connection (102, 104) between the first and second output terminals (76, 78) of said one safety switching device (50) and the input terminals (70, 72) of the downstream safety switching device (110) includes at least one actuator (122).

## Revendications

1. Commutateur de sécurité pour mettre en marche et mettre à l'arrêt de manière sûre un consommateur électrique (84, 124), en particulier une machine électrique, avec au moins un premier et un deuxième élément de commutation électronique (56, 58 ; 56, 58, 156, 158 ; 56, 58, 176, 178), au moins une première et une deuxième borne de sortie (76, 78 ; 76, 78, 152, 154 ; 76, 78, 172, 174) et au moins une borne d'entrée (70, 72) pour un premier signal de commutation qui agit sur les éléments de commutation (56, 58 ; 56, 58, 156, 158 ; 56, 58, 176, 178), le premier et le deuxième élément de commutation (56, 58 ; 56, 58, 156, 158 ; 56, 58, 176, 178) présentant chacun une sortie (66) qui, en fonction du premier signal de commutation, met à disposition un signal de sortie d'un premier (UB) ou d'un deuxième potentiel (masse), la sortie (66) du premier élément de commutation (56 ; 56, 156 ; 56, 176) étant reliée à la première borne de sortie (76 ; 76, 152 ; 76, 172) et la sortie (66) du deuxième élément de commutation (58 ; 58, 158 ; 58, 178) étant reliée à la deuxième borne de sortie (78 ; 78, 154 ; 78, 174), **caractérisé par** un sélecteur de mode de fonctionnement (140) qui permet de choisir entre au moins un premier et un deuxième mode de fonctionnement, les éléments de commutation (56, 58) délivrant des signaux de sortie essentiellement stationnaires dans le premier mode de fonctionnement et des signaux de sortie cadencés dans le deuxième mode de fonctionnement, les signaux de sortie essentiellement stationnaires étant tels qu'ils paraissent stationnaires à un commutateur de sécurité suivant de même type (50'), et le commutateur de sécurité suivant (50') pouvant détecter et analyser de manière ciblée les signaux de sortie cadencés, afin de détecter un court-circuit dans la liaison à la première et à la deuxième borne de sortie, les signaux de sortie cadencés n'étant pas appropriés pour exciter un relais.

2. Commutateur de sécurité selon la revendication 1, **caractérisé en ce que** chaque élément de commutation (56, 58) comprend un montage en série d'un transistor (60) et d'au moins une résistance (62), le montage en série étant alimenté par une tension d'alimentation (UB ; masse) du commutateur de sécurité de telle manière que la sortie (66) de l'élément de commutation (56, 58) peut être commutée entre les deux potentiels (UB ; masse) de la tension d'alimentation.

3. Commutateur de sécurité selon la revendication 1 ou 2, **caractérisé en ce qu'**il présente une unité de jonction logique (116) et au moins une autre borne d'entrée (112, 114) pour l'introduction d'au moins un autre signal de commutation, l'unité de jonction (116) reliant logiquement l'autre signal de commutation au nombre d'au moins un au premier signal de commutation pour former un signal de commutation combiné.

4. Commutateur de sécurité selon la revendication 3, **caractérisé en ce que** l'unité de jonction (116) relie par un ET logique les signaux de commutation.

5. Commutateur de sécurité selon l'une des revendications précédentes, **caractérisé en ce qu'**il présente au moins deux autres bornes de sortie (136, 138) ainsi qu'un générateur de cadence (134) qui fournit deux signaux de cadence différents aux deux autres bornes de sortie (136, 138).

6. Commutateur de sécurité selon l'une des revendications précédentes, **caractérisé en ce qu'**il présente une surveillance de court-circuit arrêtable (162) pour les première et deuxième bornes de sortie (76, 78, 152, 154).

7. Commutateur de sécurité selon l'une des revendications précédentes, **caractérisé en ce qu'**il présente au moins un premier et un deuxième élément de commutation complémentaire (176, 178), dont les sorties sont reliées chacune à une borne de sortie complémentaire (172, 174) du commutateur.

8. Système de commutation de sécurité avec au moins deux commutateurs de sécurité (50, 50' ; 50, 110 ; 132, 50') selon l'une des revendications précédentes, **caractérisé en ce que** les commutateurs de sécurité au nombre d'au moins deux sont montés en série de telle matière que les première et deuxième bornes de sortie (76, 78) d'un commutateur de sécurité (50 ; 132) sont reliées aux bornes d'entrée (70, 72) du commutateur de sécurité (50' ; 110) suivant.

9. Système de commutation de sécurité selon la revendication 8, **caractérisé en ce que** la liaison (102, 104) entre les première et deuxième bornes de sortie (76, 78) d'un commutateur de sécurité (50) et les bornes d'entrée (70, 72) du commutateur de sécurité (50') suivant comprend au moins un commutateur (106).

10. Système de commutation de sécurité selon la revendication 8 ou 9, **caractérisé en ce que** la liaison (102, 104) entre les première et deuxième bornes de sortie (76, 78) d'un commutateur de sécurité (50) et les bornes d'entrée (70, 72) du commutateur de sécurité (110) suivant comprend au moins un actionneur (122).
